Europäisches Patentamt

European Patent Office

Office européen des brevets

(11) Veröffentlichungsnummer: **0 359 159**
**A2**

## EUROPÄISCHE PATENTANMELDUNG

(21) Anmeldenummer: 89116724.9

(22) Anmeldetag: 09.09.89

(51) Int. Cl.5 **B01J 3/03** , //C30B35/00

(30) Priorität: 12.09.88 DE 3830929

(43) Veröffentlichungstag der Anmeldung:
21.03.90 Patentblatt 90/12

(84) Benannte Vertragsstaaten:
**CH DE FR GB IT LI NL SE**

(71) Anmelder: **Forschungszentrum Jülich GmbH
Postfach 1913
D-5170 Jülich(DE)**

(72) Erfinder: **Heybutzki, Helmut
Kommstrasse 13
D-5170 Jülich(DE)**
Erfinder: **Krug, Wolfgang
Siemensstrasse 18
D-5170 Jülich(DE)**
Erfinder: **Seferiadis, Johann
Im Wiesengrund 5
D-5170 Jülich(DE)**

(54) **Drehdurchführung für Rezipienten mit heisser Wandung.**

(57) Die Erfindung bezieht sich auf eine Drehdurchführung für Rezipienten mit heißer Wandung. Sie löst die Aufgabe, eine leckfreie Übertragung der Drehbewegung in den Rezipienten auch dann zu ermöglichen, wenn die Wandung des Rezipienten sich auf Temperaturen oberhalb 500°C befindet. Erfindungsgemäß besteht die Drehdurchführung aus einer mit der Wandung verbundenen Hülse, in die eine Welle eingepaßt ist. Das obere Ende der Hülse ist topfförmig erweitert und/oder unterhalb des unteren Ende der Hülse ist ein nach oben offener Topf vorgesehen, der mit der Welle dicht verbunden ist und der das untere Ende der Hülse umgreift. Der Spalt zwischen Welle und Hülse ist mit Hilfe einer geeigneten Dichtungsflüssigkeit, beispielsweise flüssiges Boroxid, gasgedichtet.

FIG. 1

## Drehdurchführung für Rezipienten mit heißer Wandung

Die Erfindung bezieht sich auf eine Drehdurchführung gemäß dem Oberbegriff des Anspruchs 1.

Die leckfreie Übertragung von Drehbewegungen in einen Rezipienten mit heißer Wandung bei Temperaturen oberhalb 500° C ist, insbesondere bei korrosiver Atmosphäre, ein bisher nicht gelöstes technisches Problem.

Derartige Drehdurchführungen werden beispielsweise benötigt bei Kristallzuchtapparaturen mit geschlossenem, beheiztem Rezipienten, bei denen der Kristall aus der Schmelze gezogen wird und hierzu im Rezipienten an der senkrecht angeordneten Welle hängt und/oder der Tiegel auf einer drehbaren Welle steht.

Es ist Aufgabe der Erfindung, eine Drehdurchführung der eingangs bezeichneten Art zu schaffen, die eine leckfreie Übertragung der Drehbewegung in den Rezipienten auch dann möglich macht, wenn die Wandung des Rezipienten sich auf Temperaturen oberhalb 500° C befindet.

Diese Aufgabe wird erfindungsgemäß durch eine Drehdurchführung mit den kennzeichnenden Merkmalen des Anspruchs 1 gelöst.

Der Spalt zwischen Welle und Hülse spielt in Kombination mit einer Dichtungsflüssigkeit geeigneter Viskosität in dieser Erfindung eine entscheidende Rolle. Dabei soll die Welle so in die Hülse eingepaßt, und somit der Spalt so ausgelegt sein, daß die Drehdurchführung gasgedichtet wird, daß eine Drehung der Welle ermöglicht wird, und daß begrenzte Druckunterschiede zwischen beiden Seiten der Drehdurchführung ausgehalten werden. Bei der Wahl der Dichtungsflüssigkeit, zweckmäßigerweise Boroxid ($B_2O_3$), lassen sich grundsätzlich zwei Betriebsmoden der Drehdurchführung einstellen. Bei vorgegebener Viskosität der Dichtungsflüssigkeit ist für den sog. Trockenlauf ein enger Spalt zu wählen (für ($B_2O_3$ als Dichtungsflüssigkeit im Bereich 10 bis 15 $\mu$m). Dabei wird die Gasdichtung durch Abdichtung wenigstens eines der beiden Enden des Spaltes mit Hilfe der Dichtungsflüssigkeit erreicht, ohne daß die Dichtungsflüssigkeit wesentlich in den Spaltbereich zwischen Welle und Hülse gelangt. Für den Fall, daß man einen breiten Spalt wählt (für ($B_2O_3$ als Dichtungsflüssigkeit > 20 $\mu$m), wird die Drehdurchführung in einer Version betrieben, bei der sich der Spalt zwischen Welle und Hülse mit soviel Dichtungsflüssigkeit füllt, daß die Gasdichtung gesichert ist. Unabhängig von der gewählten Betriebsmode ist zu beachten, daß Welle und Hülse sich grundsätzlich nicht berühren. Die Gasdichtung wird ausschließlich mit Hilfe der Dichtungsflüssigkeit realisiert. Dabei wird die Welle mittels eines sich außerhalb des heißen Bereichs befindlichen, ortsfesten Lagers gelagert.

Bei einer Ausführungsart der erfindungsgemäßen Vorrichtung ist das obere Ende der Hülse zur Aufnahme der Dichtungsflüssigkeit topfförmig erweitert. Dies ist von besonderer Bedeutung für den Fall, daß oberhalb der Drehdurchführung ein Überdruck existiert. Vorausgesetzt wird, daß im Topf immer genügend Flüssigkeit vorhanden ist, um die Gasdichtung zu gewährleisten. Man kann als Dichtungsflüssigkeit zum Beispiel $HfF_4$ oder $ZrF_4$ verwenden. Als weitgehend chemisch und thermisch stabile, nichtzersetzbare Dichtungsflüssigkeit mit niedrigem Dampfdruck erweist sich der Einsatz von flüssigem Boroxid als besonders vorteilhaft.

Die Drehdurchführung kann gemäß der Erfindung auch mit einem unterhalb des unteren Endes der Hülse mit der Welle dicht verbundenen, nach oben offenen, zur Aufnahme der Dichtungsflüssigkeit vorgesehenen Topf, der das untere Ende der Hülse umgreift, versehen sein. Somit wird die Gasdichtung des Spaltes zwischen Welle und Hülse auf der unteren Seite der Drehdurchführung ermöglicht, wenn das untere Ende der Welle sich in der sich im Topf befindlichen Dichtungsflüssigkeit befindet. Dies ist von besonderer Bedeutung für den Fall, daß unterhalb der Drehdurchführung ein Überdruck existiert.

Bei einer besonders zweckmäßigen Ausführungsform der Drehdurchführung ist sowohl das obere Ende topfförmig erweitert als auch der untere Topf vorgesehen. Für den Fall des Trockenlaufs ermöglicht die Dichtungsflüssigkeit in beiden Töpfen dann eine zweifache, beidseitige Gasdichtung der Drehdurchführung.

Besonders vorteilhaft ist die Durchführung gerade dann, wenn sie neben einer Dreh- zugleich eine Hubbewegung der Welle ermöglicht. Eine besonders vorteilhafte Ausführungsform der Drehdurchführung ist gegeben gemäß den Merkmalen nach Anspruch 3, denn sie ermöglicht neben einer Drehbewegung der Welle zugleich die Hubbewegung einer die Durchführung durchdringenden Stange. Diese Ausführungsform erweist sich besonders vorteilhaft hinsichtlich des Schutzes des Materials, aus dem der Faltenbalg hergestellt ist, z.B. wenn eine korrosive Atmosphäre in dem Rezipienten vorhanden ist.

Die Drehdurchführung gemäß der Erfindung ist in den Zeichnungen schematisch dargestellt und wird im folgenden näher erläutert.

Es zeigen:

Figur 1 Rezipient mit zwei Drehdurchführungen;

Figur 2 Rezipient mit zwei Drehdurchführungen mit axial bewegbarer Stange.

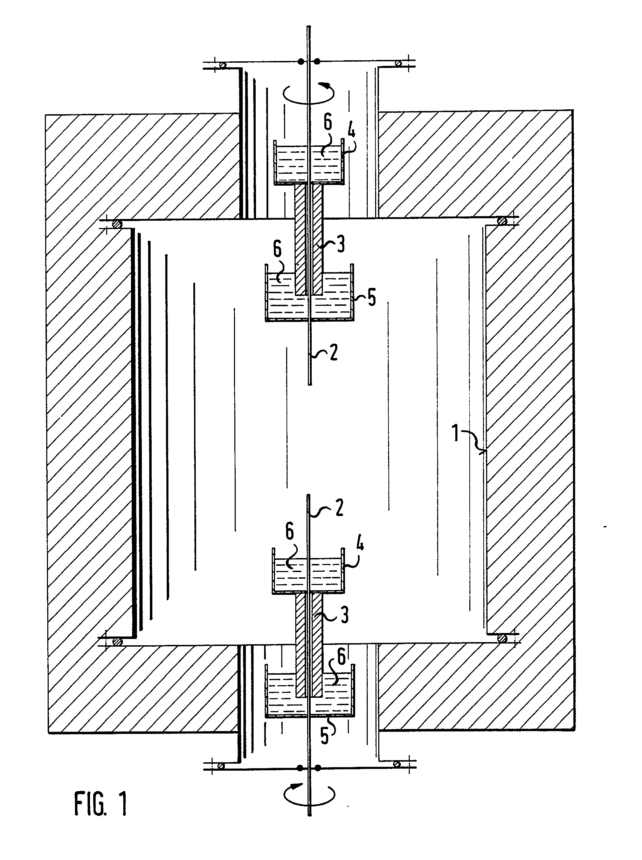

In der Figur 1 ist die Drehdurchführung für einen Rezipienten mit heißer Wandung 1 dargestellt, das von der Welle 2 senkrecht oder quasi senkrecht durchdrungen wird. Dabei ist die Hülse 3 fest mit der Wand verbunden und in Form des Topfes 4 erweitert. Unterhalb des unteren Ende der Hülse befindet sich ein mit der Welle dicht verbundener, nach oben offener Topf 5, der wie die topfförmige Erweiterung am oberen Ende der Hülse die Dichtflüssigkeit 6, vornehmlich Boroxid, enthält. Testversuche mit Boroxid als Dichtungsflüssigkeit bei einer Betriebstemperatur von 700 °C zeigten, daß Druckdifferenzen auf beiden Seiten einer solchen Drehdurchführung bis zu 1 bar ausgehalten werden bei einer Spaltbreite von 10 bis 50 μm.

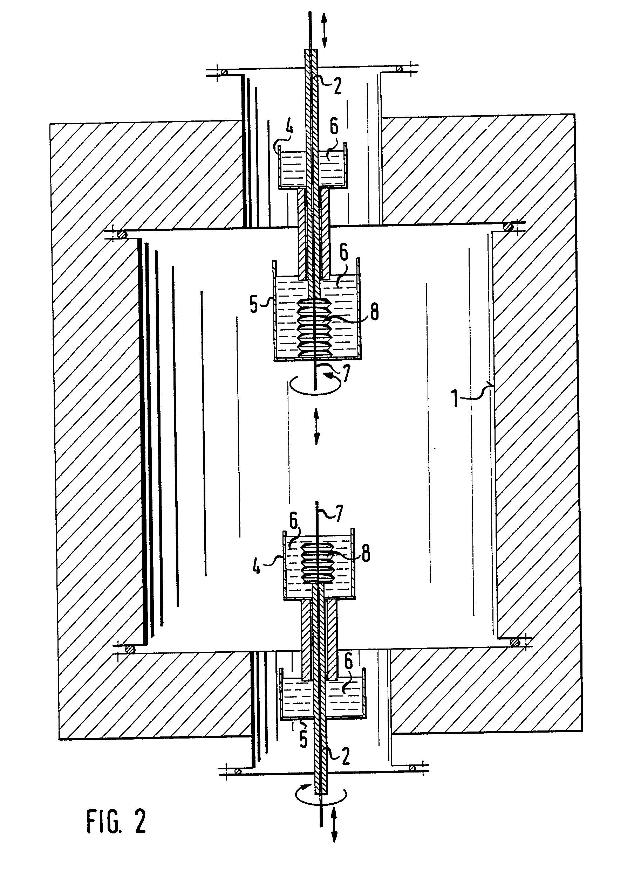

Die Figur 2 zeigt die Ausführungsart der Durchführung, die die Hubbewegung einer die Drehdurchführung durchdringenden Stange 7 ermöglicht. Die Figur 2 zeigt außerdem einen Faltenbalg 8, der den Zwischenraum zwischen der Welle und der Stange gasdichtet, indem er mit dem einen Ende an einem Ende der Welle und mit dem anderen Ende mit der Stange dicht verbunden ist. Für den Fall, daß der Faltenbalg in dem Topf von der Dichtungsflüssigkeit vollständig umgeben wird, wie in Figur 2 dargestellt ist, ist er besonders vorteilhaft geschützt vor korrosiver Atmosphäre in dem Rezipienten, wie durch Tests bei Temperaturen bis zu 700 °C belegt wurde. Dabei wurde zum Beispiel als Material für die Welle stellitgepanzertes Edelstahl, für die Hülse Graphit mit Edelstahlgehäuse, für die Töpfe und den Faltenbalg ebenfalls Edelstahl verwendet.

In beiden Ausführungsbeispielen wurde die Welle außerhalb des heißen Bereichs mit Hilfe eines ortsfesten Lagers in an sich bekannter Weise gelagert.

## Ansprüche

1. Drehdurchführung für Rezipienten mit heißer Wandung zur Übertragung der Drehbewegung einer senkrecht angeordneten, die Wandung des Rezipienten durchdringenden, drehbaren Welle, **dadurch gekennzeichnet,** daß die Drehdurchführung aus einer mit der Wandung (1) verbundenen Hülse (3) besteht, in die die Welle (2) eingepaßt ist, daß das obere Ende der Hülse topfförmig erweitert ist und/oder unterhalb des unteren Endes der Hülse ein mit der Welle dicht verbundener, nach oben offener Topf (5) vorgesehen ist, der das untere Ende der Hülse umgreift und daß der Spalt zwischen Welle und Hülse mit Hilfe einer geeigneten Dichtungsflüssigkeit (6) gasgedichtet ist.

2. Drehdurchführung nach Anspruch 1, **dadurch gekennzeichnet,**
daß als Dichtungsflüssigkeit (6) Boroxid vorgesehen ist.

3. Drehdurchführung nach Anspruch 1 oder 2, **dadurch gekennzeichnet,**
daß

a) die Welle (2) hohl ausgebildet ist,

b) eine axial bewegbare Stange (7) enthält und

c) ein Faltenbalg (8), der an einem Ende mit einem Ende der Welle, an dem anderen Ende mit der Stange dicht verbunden ist, vorgesehen ist und

d) der Faltenbalg sich derart im Topf (4, 5) befindet, daß er vollständig von der Dichtungsflüssigkeit (6) umgeben ist.

FIG. 1

FIG. 2